# EUROPEAN PATENT SPECIFICATION

(11) **EP 0 309 243 B1**
(45) Date of publication and mention of the grant of the patent: **18.08.1993**
(21) Application number: 88308797.5
(22) Date of filing: 22.09.1988
(51) Int. Cl.: C23C 18/22

(54) **Pre-etch treatment of a plastics substrate**
Vorätzbehandlung eines Plastiksubstrats
Traitement de pré-décapage d'un substrat plastique

(30) Priority: 25.09.1987 GB 8722643; 23.12.1987 GB 8730038
(43) Date of publication of application: 29.03.1989
(73) Proprietor: ENGELHARD TECHNOLOGIES LIMITED, Daventry Northamptonshire NN11 4HF (GB)
(72) Inventor: James, Barry Sydney, Northamptonshire, NN11 6AZ (GB)
(74) Representative: Fisher, Adrian John

(56) References cited:
- EP-A- 0 092 601
- DE-A- 3 708 909
- US-A- 4 125 649

## Description

The present invention relates to a solvent composition for use in preparing the surface of a plastics material for plating with a metal, to a method of preparing the surface of a plastics material using such a solvent composition, and to the production of metal-plated articles comprising a substrate of plastics material, the surface of which plastics material was prepared for plating by such a method.

### Background to the invention

There is an increasing demand for articles of plastics materials plated with a metal. Such articles combine the appearance of solid metal with the lightness and relative cheapness of a plastics material. Further, there is an increasing demand in the electronics industries for metal-plated plastics in the form of casings for electronic apparatus as the metal coating can provide essential EMF shielding which could otherwise only be provided by a much heavier and more costly solid metal housing.

It is known that plastics materials, which are electrically non-conductive, can be plated by a procedure that involves etching the surface of the plastics material, sensitizing the etched surface by applying to it a very thin layer (e.g. of molecular thickness) of a noble metal such as palladium or platinum, applying a coating of a conductive metal, such as copper, to the sensitized surface using an autocatalytic electroless solution, and forming a thicker metal coating by electrolysis.

The above-mentioned etching step is of great importance because it is thought that it is the etching of the surface of the plastics material that enables it to form a bond with the metal plating. Etching is generally preceded by degreasing using a caustic detergent mixture. After rinsing, the surface of the plastics material is then generally pre-etched with a solvent, for example an aqueous solution of a chlorinated solvent as disclosed in GB-A-1,544,456. Solvent pre-etching is intended to improve the adhesion between the plastics surface and the metal plated thereon, although it is not required for every plastics material: for example, some grades of acrylonitrile-butadiene-styrene (ABS) resin do not require a solvent pre-etch step. Whether or not solvent pre-etching has been carried out, the plastics material is subjected to a chromic acid etch, and it is during this chromic acid etching that the appearance of the surface of the plastics materials begins to change by the formation of very fine surface cracks. It is this fine surface cracking that provides the key and enables the subsequently plated metal layer to form a strong bond with the plastics material surface.

After the chromic acid etching step, and prior to the metal plating steps, the surface of the plastics material is thoroughly rinsed.

The chlorinated solvents currently used for the solvent pre-etch are notorious pollutants and investigations have therefore been carried out in an attempt to find an alternative solvent composition for the solvent pre-etch step which is less environmentally harmful.

### Summary of the invention

The present invention now provides a solvent composition for use in preparing the surface of a plastics material for plating with a metal, which solvent composition comprises an aqueous solution containing
(i) a compound of the general formula

   R¹COO.(CH₂CH₂O)ₙ.R² (1)

   wherein
   R¹ is H or C₁-C₆ alkyl,
   R² is C₁-C₆ alkyl and
   n is an integer from 1 to 5 inclusive,
and (ii) a surfactant, being other than a compound of the general formula (1).

The components (i) and (ii) should be dissolved in the aqueous medium. Thus, if appropriate, component (i) may be solubilized by a component (iii) selected from (a) compounds of the general formula

HO.(CH₂CH₂O)ₘ.R³ (2)

wherein
R³ is C₁-C₆ alkyl and
m is an integer from 1 to 5 inclusive, and (b) compounds of the general formula

CH₃.(OH)CH.CH₂(OC₃H₆)ₚ.R⁴ (3)

wherein
R⁴ is C₁-C₆ alkyl and
p is zero or an integer from 1 to 5 inclusive.

The invention also provides a method of preparing the surface of a plastics material for plating with a metal, which method comprises applying to the said surface a solvent composition of this invention.

Further, the present invention provides a process for producing a metal-plated article comprising a substrate of plastics material, which process comprises preparing the surface of the plastics material for plating by a method of this invention and plating a metal onto the surface so prepared.

The compounds of the general formula (1), when used in accordance with the present invention, have been found to be effective in the solvent pre-etching of plastics substrates and yet are much less environmentally harmful than the conventionally used chlorinated solvents. Furthermore, the present invention permits the formulation of a solvent composition in which the active components have a low evaporation rate and a high flash point, which are important considerations in terms of economy and safety in industrial practice.

### Description of preferred embodiments.

The expression "alkyl" includes both straight-chain and branched alkyl radicals.

In the preferred compounds of the general formula (1) R¹ is H or methyl (CH₃), R² is methyl, ethyl (C₂H₅) or C₃-C₆ alkyl, especially propyl (C₃H₇) or butyl (C₄H₉), and n is 1, 2 or 3.

As component (i) it is particularly preferred to use diethylene glycol monobutyl ether acetate (CH₃COO.CH₂CH₂OCH₂CH₂0.C₄H₉), diethylene glycol monoethyl ether acetate (CH₃COO.CH₂CH₂OCH₂CH₂O.C₂H₅) or a mixture thereof.

An appropriate concentration of component (i) in the solvent composition can be readily selected by a person skilled in the art having regard to the conditions under which the pre-etching of the plastics substrate is to be carried out. Low concentrations of component (i) may be used, although this may require a long immersion time, which could be unacceptable in an automatic plant, and/or a relatively high temperature, which will increase the loss of materials due to evaporation or hydrolysis. Relatively high concentrations of component (i) may also be used in the solvent composition and the immersion time and the temperature adjusted to give satisfactory adhesion of the metal to the plastics surface during the subsequent plating step. The use of high concentrations will, of course, give rise to a high consumption of materials and increases the risk of component (i) being carried over and interfering with the activity of the chemicals used later in the plating sequence.

As a guide, diethylene glycol monoethyl ether acetate is preferably used at a concentration of 20 to 25% by weight in the aqueous solvent composition. Diethylene glycol monobutyl ether acetate may be used in the form of an aqueous solution up to its solubility limit of about 6.5% by weight (although this, of course, will vary according to the temperature used). Such a comparatively low solubility will entail the use of a long immersion time, although the solubility of the diethylene glycol monobutyl ether acetate could be increased by raising the temperature. However, long immersion times and the use of high temperatures may be impractical in an automated plant and, therefore, a coupling compound, in particular a solubilising compound of the general formula (2) or (3) above, will preferably be used in practice to increase the concentration of diethylene glycol monobutyl ether acetate or the other higher homologues of the general formula (1) (i.e. those wherein R² is alkyl with 3 or more carbon atoms). It is believed that the compounds of the formulae (2) and (3) may also help to improve the surface cracking obtained in the etching treatment.

The presence of a coupling or solubilising compound is, in general, requisite for the solvent compositions that contain only the lower homologues of the general formula (1), such as diethylene glycol monoethyl ether acetate.

Preferred compounds of the general formula (2) are those in which R³ is methyl, ethyl, propyl or butyl and m is 1, 2 or 3. Preferred compounds of the general formula (3) are those in which R⁴ is methyl, ethyl, propyl or butyl and p is 0, 1 or 2.

In general, the compounds of the general formula (2) are preferred to those of the general formula (3). A particularly preferred compound for use as component (iii) is diethylene glycol monobutyl ether (HO.CH₂CH₂OCH₂CH₂O.C₄H₉).

The solvent compositions of the present invention contain a surfactant, preferably an anionic surfactant. It is also desirable that the surfactant should be low-foaming. A preferred surfactant is 2-ethylhexyl sulfate, which is commercially available under the trademark Niaproof 08 or Tergitol 08 as an aqueous solution containing 38.5 to 40.5% by weight of the sodium salt, C₄H₉.CH(C₂H₅)CH₂SO₄.Na; this surfactant does not generate much foam and appears capable of solubilizing the component (i). (Thus, as verified in Example 4 hereinafter, the use of additional solubilizing surfactant wholly or partly to replace component (iii) may be considered.) However, other surfactants come into consideration, including C₄H₉CH(C₂H₅)C₂H₄CH(SO₄Na)C₂H₄CH(C₂H₅)₂ (Tergitol 7), (C₄H₉CH(C₂H₅)C₂H₄CH(SO₄Na)CH₂CH(CH₃)₂ (Tergitol 4) and dodecylated diphenyl ether disulfonate, which is available as the sodium salt under the trademark Dowfax 2A1, although the last-mentioned surfactant can generate considerable foam and does not appear on its own to solubilise the component (i).

The relative proportions of the components of the solvent compositions may be adjusted according to the conditions of use. Preferably, 0.625 to 2.5 parts by weight of surfactant component (ii) and 0.5 to 2 parts by weight of solubilising component (iii) (if used) will be present per part by weight of component (i). A typical solvent composition may contain one part of component (i), 1.33 parts of component (ii) and one part of component (iii). The total concentration of components (i), (ii) and (iii) will commonly be at least 20% by weight of the solvent composition, typically up to 40% by weight or even higher.

Expressed in different terms, preferred compositions of the invention may comprise, in aqueous solution, 50-250, especially 96-168, ml/l of component (i), 50-200, especially 96-144, ml/l of component (ii) (as supplied, for instance as a nominal 40% solution) and 50-200, especially 96-144, ml/l of a solubilizing agent, especially a component (iii). These concentrations are particularly suitable for compositions comprising (i) diethylene glycol monobutyl ether acetate, (ii) Niaproof 08 and (iii) diethylene glycol monobutyl ether.

The present invention also contemplates the provision of a concentrated mixture (typically with a water content of 400 ml/l down to 250 ml/l or even lower) containing component (i), component (ii) and, if appropriate, component (iii), which may be more economical to transport to the end-user and which may be diluted with water, as appropriate, before use.

It will be understood by those skilled in the art that any of components (i), (ii) and (iii) may be composed of a mixture of two or more compounds of the appropriate description. Furthermore, the presence of one or more additional, non-deleterious components is not precluded.

The solvent composition according to this invention can be used to pre-etch the surface of a variety of plastics materials, for example, polycarbonates, polysulphones, polyesters and ABS resins.

The surface of the plastics material is preferably treated by dipping it into the aqueous solvent composition at a temperature and for a period of time sufficient to ensure a satisfactory adhesion between the plastics surface and the metal to be plated thereon in a subsequent stage. Preferably, the surface of the plastics material is immersed in the solvent composition for 2 to 5 minutes, more preferably 3 to 5 minutes, at a temperature in the range of from 50 to 60°c, typically at 55°C. After removal from the solvent composition and rinsing, the surface of the plastics material may then be etched with chromic acid, which causes the appearance of the surface cracking referred to above, and is then rinsed again. The etched surface may then be plated in a conventional manner, for example by means of a sensitizing step with a noble metal, followed by the application of a conductive metal coating from an electroless solution, followed by the electrolytic deposition of a final, thicker metal coating.

As pre-etching proceeds, the aqueous solvent solution may become low in active compounds for a number of reasons, such as drag out and absorption by the plastics material surface. To correct for this loss of active compound, a maintenance solution containing higher concentrations of the active compounds can be added to the pre-etch solution, as appropriate. The composition of the maintenance solution will depend upon a number of factors, including the quantity, size and shape of the component being pre-etched. However, for guidance, a typical maintenance solution may contain 200-400 ml/l diethylene glycol monobutyl ether acetate (also referred to herein as butyl diglycol acetate), 200-300 ml/l diethylene glycol monobutyl ether (butyl Carbitol; "Carbitol" being a trademark) and 200-300 ml/l Niaproof 08 solution (38.5-40.5% by weight of active compound), the remainder of the maintenance solution being water.

The present invention is illustrated in and by the following Examples.

### Example 1

An aqueous pre-etching solution containing 80 ml/l butyl diglycol acetate, 80 ml/l Niaproof 08 and 80 ml/l butyl carbitol was prepared. The solution was heated to 55°C and panels of filled polycarbonate (Lexan 920A grade from Messrs. GE Plastics) were immersed in it for respectively 2, 3, 4 or 5 minutes, after which they were rinsed in water and immersed for 20 minutes at 75°C in an etching solution containing 500 g/l chromic acid (CrO₃) and 350 g/l concentrated sulphuric acid. The panels were then rinsed again with water and the chromic acid neutralised. A thin layer of palladium was then applied to the panels over which was coated copper and nickel by the electroless process. (The conventional electrolytic deposition of a final thick coating was omitted in order not to obscure any crack pattern that may be visible through the initial metal deposits.)

After drying, the panels were visually examined and the adhesion of the metal coating measured. The results are summarised in Table 1.

**Table 1**

| Immersion time in pre-etching solution/minutes | Adhesion of metallic coating and appearance |
|---|---|
| 2 | Poor adhesion; no cracks, numerous spots |
| 3 | Moderate adhesion; some cracking but spots when cracking not present |
| 4 | Good adhesion; regular even crack pattern |
| 5 | Good adhesion; even crack pattern |

### Example 2

A pre-etching solution was prepared containing 100 ml/l butyl diglycol acetate, 100 ml/l butyl carbitol, 100 ml/l Niaproof 08 and made up with water.

Polycarbonate panels were immersed in the solution for 2, 3, 4 or 5 minutes at 55°C and then processed further, as described in Example 1. The results are summarised in Table 2.

**Table 2**

| Immersion time in pre-etching solution/minutes | Adhesion of metallic coating and appearance |
|---|---|
| 2 | Poor adhesion, no crack pattern, badly spotted |
| 3 | Good adhesion, good crack patterns |
| 4 | Good adhesion, good crack patterns |
| 5 | Good adhesion, good crack patterns |

### Example 3

A pre-etching solution was prepared containing 120 ml/l butyl diglycol acetate, 120 ml/l butyl carbitol and 100 ml/l Niaproof 08 made up with water. Polycarbonate panels were immersed in the solution for 2, 3, 4 or 5 minutes at 55°C and then further processed as described in Example 1.

Each panel exhibited good adhesion and had a good crack pattern.

### Example 4

A solution was prepared containing 132 ml/l butyl diglycol acetate and 255 ml/l Niaproof 08 solution (38-40% by weight in water). Polycarbonate panels were immersed for 1, 2, 3, 4 or 5 minutes in this solution at 55°C and then further processed as described in Example 1.

Each panel exhibited good adhesion and a good crack pattern.

It will of course be understood that the present invention has been described above purely by way of example, and modifications of detail can be made within the scope of the invention.

## Claims

1. A solvent composition for use in preparing the surface of a plastics material for plating with a metal, which solvent composition comprises an aqueous solution containing
(i) a compound of the general formula
R¹COO.(CH₂CH₂O)ₙ.R² (1)
wherein
R¹ is H or C₁-C₆ alkyl,
R² is C₁-C₆ alkyl and
n is an integer from 1 to 5 inclusive,
and (ii) a surfactant being other than a compound of the general formula (1), with the proviso that, when component (i) does not comprise a compound wherein R² is alkyl with 3 or more carbon atoms, the composition also contains (iii) a compound selected from the group consisting of
(a) compounds of the general formula
HO.(CH₂CH₂O)ₘ.R³ (2)
wherein
R³ is C₁-C₆ alkyl and
m is an integer from 1 to 5 inclusive,
and (b) compounds of the general formula
CH₃.(OH)CH.CH₂(OC₃H₆)ₚ.R⁴ (3)
wherein
R⁴ is C₁-C₆ alkyl and
p is zero or an integer from 1 to 5 inclusive.

2. A solvent composition according to claim 1, containing a compound of the general formula (1) wherein R¹ is H or methyl, R² is methyl, ethyl, propyl or butyl and n is 1, 2 or 3.

3. A solvent composition according to claim 1, wherein component (i) is selected from the group consisting of diethylene glycol monobutyl ether acetate, diethylene glycol monoethyl ether acetate and mixtures thereof.

4. A solvent composition according to claim 1, 2 or 3, containing an anionic surfactant.

5. A solvent composition according to any of claims 1 to 4, containing sodium 2-ethylhexyl sulfate as a surfactant.

6. A solvent composition according to any of claims 1 to 5, in which component (i) comprises a compound wherein R² is alkyl with 3 or more carbon atoms, said solvent composition also containing (iii) a solubilising compound selected from the group consisting of (a) compounds of the formula (2) as defined in claim 1 and (b) compounds of the formula (3) as defined in claim 1.

7. A solvent composition according to any of claims 1 to 6, containing a compound of the general formula (2) wherein R³ is methyl, ethyl, propyl or butyl and m is 1, 2 or 3.

8. A solvent composition according to claim 7, wherein the compound of the general formula (2) is diethylene glycol butyl ether.

9. A method of preparing the surface of a plastics material for plating with a metal, which method comprises applying to the said surface a solvent composition that comprises an aqueous solution containing (i) a compound of the general formula
R¹COO.(CH₂CH₂O)ₙ.R² (1)
wherein
R¹ is H or C₁-C₆ alkyl,
R² is C₁-C₆ alkyl and
n is an integer from 1 to 5 inclusive,
and (ii) a surfactant being other than a compound of the general formula (1), with the proviso that, when component (i) does not comprise a compound wherein R² is alkyl with 3 or more carbon atoms, the composition also contains (iii) a compound selected from the group consisting of
(a) compounds of the general formula
HO.(CH₂CH₂O)ₘ.R³ (2)
wherein
R³ is C₁-C₆ alkyl and
m is an integer from 1 to 5 inclusive,
and (b) compounds of the general formula
CH₃.(OH)CH.CH₂(OC₃H₆)ₚ.R⁴ (3)
wherein
R⁴ is C₁-C₆ alkyl and
p is zero or an integer from 1 to 5 inclusive.

10. A method according to claim 9, in which the solvent composition is according to any one of claims 2 to 8.

11. A process for producing a metal-plated article comprising a substrate of plastics material, which process comprises preparing the surface of the said plastics material for plating by a method according to claim 9 or 10 and plating a metal onto the surface so prepared.

12. A concentrate from which a pre-etch solvent composition may be prepared by dilution with water, said concentrate containing (i) a compound of the general formula (1) as defined in claim 1, (ii) a surfactant, being other than a compound of the general formula (1), and (iii) a compound of the general formula (2) or (3) as defined in claim 1.

## Patentansprüche

1. Lösungsmittelzusammensetzung zur Verwendung bei der Vorbereitung der Oberfläche eines Kunststoffmaterials zum Plattieren mit einem Metall, wobei diese Lösungsmittelzusammensetzung eine wäßrige Lösung umfaßt, welche enthält
(i) eine Verbindung der allgemeinen Formel
R¹COO.(CH₂CH₂O)ₙ.R² (1)
worin
R¹ H oder C₁-C₆-Alkyl ist,
R² C₁-C₆-Alkyl ist und
n eine ganze Zahl von 1 bis einschließlich 5 ist,
und (ii) ein anderes oberflächenaktives Mittel als eine Verbindung der allgemeinen Formel (1), mit der Maßgabe, daß, wenn die Komponente (i) nicht eine Verbindung umfaßt, worin R² Alkyl mit 3 oder mehr Kohlenstoffatomen ist, die Zusammensetzung auch (iii) eine Verbindung enthält, ausgewählt aus der Gruppe, bestehend aus
(a) Verbindungen der allgemeinen Formel
HO.(CH₂CH₂O)ₘ.R³ (2)
worin
R³ C₁-C₆-Alkyl ist und
m eine ganze Zahl von 1 bis einschließlich 5 ist, und
(b) Verbindungen der allgemeinen Formel
CH₃.(OH)CH.CH₂(OC₃H₆)ₚ.R⁴ (3)
worin
R⁴ C₁-C₆-Alkyl ist und
p 0 oder eine ganze Zahl von 1 bis einschließlich 5 ist.

2. Lösungsmittelzusammensetzung nach Anspruch 1, welche eine Verbindung der allgemeinen Formel (1) enthält, worin R¹ H oder Methyl ist, R² Methyl, Ethyl, Propyl oder Butyl ist und n 1, 2 oder 3 ist.

3. Lösungsmittelzusammensetzung nach Anspruch 1, worin die Komponente (i) ausgewählt wird aus der Gruppe, bestehend aus Diethylenglykolmonobutyletheracetat, Diethylenglykolmonoethyletheracetat und Gemischen davon.

4. Lösungsmittelzusammensetzung nach Anspruch 1, 2 oder 3, welche ein anionisches oberflächenaktives Mittel enthält.

5. Lösungsmittelzusammensetzung nach einem der Ansprüche 1 bis 4, welche Natrium-2-ethylhexylsulfat als oberflächenaktives Mittel enthält.

6. Lösungsmittelzusammensetzung nach einem der Ansprüche 1 bis 5, in welcher die Komponente (i) eine Verbindung umfaßt, worin R² Alkyl mit 3 oder mehr Kohlenstoffatomen ist, wobei die Lösungsmittelzusammensetzung auch (iii) eine löslichmachende Verbindung enthält, die ausgewählt wird aus der Gruppe, bestehend aus (a) Verbindungen der Formel (2), wie sie in Anspruch 1 definiert ist, und (b) Verbindungen der Formel (3), wie sie in Anspruch 1 definiert ist.

7. Lösungsmittelzusammensetzung nach einem der Ansprüche 1 bis 6, welche eine Verbindung der allgemeinen Formel (2) enthält, worin R³ Methyl, Ethyl, Propyl oder Butyl ist und m 1, 2 oder 3 ist.

8. Lösungsmittelzusammensetzung nach Anspruch 7, worin die Verbindung der allgemeinen Formel (2) Diethylenglykolbutylether ist.

9. Verfahren zum Vorbereiten der Oberfläche eines Kunststoffmaterials zum Plattieren mit einem Metall, wobei das Verfahren das Auftragen einer Lösungsmittelzusammensetzung, die eine wäßrige Lösung umfaßt, welche (i) eine Verbindung der allgemeinen Formel
R¹COO.(CH₂CH₂O)ₙ.R² (1)
worin
R¹ H oder C₁-C₆-Alkyl ist,
R² C₁-C₆-Alkyl ist und
n eine ganze Zahl von 1 bis einschließlich 5 ist,
und (ii) ein anderes oberflächenaktives Mittel als eine Verbindung der allgemeinen Formel (1) enthält, mit der Maßgabe, daß, wenn die Komponente (i) nicht eine Verbindung umfaßt, worin R² Alkyl mit 3 oder mehr Kohlenstoffatomen ist, die Zusammensetzung auch (iii) eine Verbindung enthält, ausgewählt aus der Gruppe, bestehend aus
(a) Verbindungen der allgemeinen Formel
HO.(CH₂CH₂O)ₘ.R³ (2)
worin
R³ C₁-C₆-Alkyl ist und
m eine ganze Zahl von 1 bis einschließlich 5 ist, und
(b) Verbindungen der allgemeinen Formel
CH₃.(OH)CH.CH₂(OC₃H₆)ₚ.R⁴ (3)
worin
R⁴ C₁-C₆-Alkyl ist und
p 0 oder eine ganze Zahl von 1 bis einschließlich 5 ist,
auf die Oberfläche umfaßt.

10. Verfahren nach Anspruch 9, in welchem die Lösungsmittelzusammensetzung nach einem der Ansprüche 2 bis 8 ist.

11. Verfahren zum Herstellen eines Metall-plattierten Artikels, welcher ein Substrat aus Kunststoffmaterial umfaßt, wobei das Verfahren das Vorbereiten der Oberfläche des Kunststoffmaterials zum Plattieren durch ein Verfahren nach Anspruch 9 oder 10 und das Plattieren eines Metalls auf die so vorbereitete Oberfläche umfaßt.

12. Konzentrat, aus dem eine Vorätz-Lösungsmittelzusammensetzung durch Verdünnung mit Wasser hergestellt werden kann, wobei das Konzentrat (i) eine Verbindung der allgemeinen Formel (1) wie in Anspruch 1 definiert, (ii) ein oberflächenaktives Mittel, welches verschieden von einer Verbindung der allgemeinen Formel (1) ist, und (iii) eine Verbindung der allgemeinen Formel (2) oder (3), wie in Anspruch 1 definiert, enthält.

## Revendications

1. Composition de solvant servant à apprêter la surface d'une matière plastique pour placage par un métal, composition de solvant qui comprend une solution aqueuse contenant :
(i) un composé de formule générale :
R¹COO.(CH₂CH₂O)ₙ.R² (1)
dans laquelle R¹ représente H ou un radical alkyle en C₁₋₆, R² est un radical alkyle en C₁₋₆ et n est un nombre entier de 1 à 5 inclus, et
(ii) un agent tensioactif autre qu'un composé de formule générale (1), à la condition que, lorsque le composant (i) ne comprend pas un composé dans lequel R² est un radical alkyle de 3 atomes de carbone ou plus, la composition renferme également
(iii) un composé choisi parmi
(a) des composés de formule générale :
HO.(CH₂CH₂O)ₘ.R³ (2)
dans laquelle
R³ est un radical alkyle en C₁₋₆ et m est un nombre entier de 1 à 5 inclus,
et (b) des composés de formule générale :
CH₃.(OH)CH.CH₂(OC₃H₆)ₚ.R⁴ (3)
dans laquelle R⁴ est un radical alkyle en C₁₋₆ et p est 0 ou un nombre entier de 1 à 5 inclus.

2. Composition de solvant selon la revendication 1, qui contient un composé de formule (1) dans laquelle R¹ est H ou un radical méthyle, R² est un radical méthyle, éthyle, propyle ou butyle et n est 1, 2 ou 3.

3. Composition de solvant selon la revendication 1, dans laquelle le composant (i) est choisi parmi l'acétate d'éther monobutylique de diéthylène-glycol, l'acétate d'éther monoéthylique de diéthylène-glycol et des mélanges de ceux-ci.

4. Composition de solvant selon la revendication 1, 2 ou 3, qui contient un tensioactif anionique.

5. Composition de solvant selon l'une quelconque des revendications 1 à 4, qui contient un sulfate 2-éthylhexylique de sodium à titre de tensioactif.

6. Composition de solvant selon l'une quelconque des revendications 1 à 5, dans laquelle le composant (i) comprend un composé dans lequel R² est un radical alkyle de 3 ou plus atomes de carbone, ladite composition de solvant contenant également (iii) un composé solubilisant choisi parmi (a) des composés de formule (2) définie dans la revendication 1 et (b) des composés de formule (3) définie dans la revendication 1.

7. Composition de solvant selon l'une quelconque des revendications 1 à 6, contenant un composé de formule générale (2) dans laquelle R³ est le radical méthyle, éthyle, propyle ou butyle et m est 1, 2 ou 3.

8. Composition de solvant selon la revendication 7, dans laquelle le composé de formule générale (2) est l'éther butylique de diéthylène-glycol.

9. Procédé de préparation de la surface d'une matière plastique pour placage avec un métal, procédé qui consiste à appliquer à ladite surface une composition de solvant qui comprend une solution aqueuse contenant (i) un composé de formule générale :
R¹COO.(CH₂CH₂O)ₙ.R² (1)
dans laquelle
R¹ est H ou un radical alkyle en C₁₋₆,
R² est un radical alkyle en C₁₋₆ et
n est un nombre entier de 1 à 5 inclus,
et (ii) un tensioactif autre qu'un composé de formule générale (1) à la condition que,quand le composant (i) ne comprend pas un composé dans lequel R² est un radical alkyle de 3 atomes de carbone ou plus, la composition renferme également (iii) un composé choisi parmi :
(a) les composés de formule générale :
HO.(CH₂CH₂O)ₘ.R³ (2)
dans laquelle
R³ est un radical alkyle en C₁₋₆ et m est un nombre entier de 1 à 5 inclus,
et
(b) les composés de formule générale :
CH₃.(OH)CH.CH₂CH₂(OC₃H₆)ₚ.R⁴ (3)
dans laquelle
R⁴ est un radical alkyle en C₁₋₆ et p est 0 ou un nombre entier de 1 à 5 inclus.

10. Procédé selon la revendication 9, dans lequel la composition de solvant est conforme à l'une quelconque des revendications 2 à 8.

11. Procédé de production d'un article plaqué par un métal, comprenant un substrat de matière plastique, procédé qui consiste à apprêter la surface de ladite matière plastique en vue d'un placage par un procédé selon la revendication 9 ou 10, et à plaquer un métal sur la surface ainsi apprêtée.

12. Concentré à partir duquel on peut préparer une composition de solvant de pré-décapage par dilution avec de l'eau, ledit concentré contenant (i) un composé de formule générale (1) définie dans la revendication 1, (ii) un tensioactif autre qu'un composé de formule générale (1) et (iii) un composé de formule générale (2) ou (3) définie dans la revendication 1.
